# EUROPÄISCHE PATENTSCHRIFT

(11) **EP 4 402 503 B1**
(45) Veröffentlichungstag und Bekanntmachung des Hinweises auf die Patenterteilung: **09.04.2025**
(21) Anmeldenummer: 22776919.7
(22) Anmeldetag: 07.09.2022
(51) Int. Cl.: H05K 3/34, G01S 7/03, H01P 5/08, H05K 1/02

(54) **RADARSENSOR MIT HOHLLEITERSTRUKTUR**
RADAR SENSOR HAVING WAVEGUIDE STRUCTURE
CAPTEUR RADAR AYANT UNE STRUCTURE DE GUIDE D'ONDES

(30) Priorität: 14.09.2021 DE 102021210123
(43) Veröffentlichungstag der Anmeldung: 24.07.2024
(73) Patentinhaber: Robert Bosch GmbH, 70442 Stuttgart (DE)
(72) Erfinder: HIMMELSTOSS, Armin, 71554 Weissach Im Tal (DE)
(86) Internationale Anmeldenummer: PCT/EP2022/074827
(87) Internationale Veröffentlichungsnummer: WO 2023/041393

(56) Entgegenhaltungen:
- JP-A- 2008 252 207
- US-A1- 2012 050 131
- US-A1- 2020 243 463
- KOICHIRO GOMI ET AL: "Low-loss GCPW-to-WG transition in multilayer resin substrate for millimeter-wave applications", MICROWAVE CONFERENCE (EUMC), 2012 42ND EUROPEAN, IEEE, 29 October 2012 (2012-10-29), pages 285 - 288, XP032328455, ISBN: 978-1-4673-2215-7

## Beschreibung

Die Erfindung betrifft einen Radarsensor mit einer Hohlleiterstruktur und einem Hochfrequenzbaustein, die auf entgegengesetzten Seiten einer Leiterplatte angeordnet sind, und mit einer Kopplungseinrichtung zur Übertragung von Mikrowellensignalen zwischen dem Hochfrequenzbaustein und der Hohlleiterstruktur.

Insbesondere befasst sich die Erfindung mit einem Radarsensor für Kraftfahrzeuge, beispielsweise zur Erfassung des Verkehrsumfelds im Rahmen eines Fahrerassistenzsystems oder autonomen Fahrsystems.

### Stand der Technik

Aus DE 10 2006 019 054 B4 ist ein Radarsensor für Kraftfahrzeuge bekannt, bei dem eine Antennenanordnung zum Senden des Radarsignals und zum Empfang des Radarechos durch eine Hohlleiterstruktur gebildet wird, die über eine Kopplungseinrichtung mit dem Hochfrequenzbaustein verbunden ist. Bei diesem Radarsensor befinden sich die Hohlleiterstruktur und der Hochfrequenzbaustein auf derselben Seite der Leiterplatte.

Es sind auch Radarsensoren vorgeschlagen worden, bei denen sich die Hohlleiterstruktur und der Hochfrequenzbaustein auf entgegengesetzten Seiten der Leiterplatte befinden, so dass die Kopplungseinrichtung das Mikrowellensignal entweder durch die Leiterplatte hindurch oder um die Leiterplatte herum übertragen muss. Beispielsweise wird die Kopplungseinrichtung in diesen Fällen durch eine durch die Leiterplatte hindurchgehende Bohrung gebildet, deren Innenflächen wahlweise metallisiert sein können, und das Innere der Bohrung ist entweder mit Luft oder einem anderen dielektrischen Material gefüllt.

Bei Kopplungseinrichtungen dieser Art sind die Übertragungseigenschaften von den Eigenschaften der Leiterplatte abhängig, insbesondere von der Dicke und dem Material der Leiterplatte oder - bei einer mehrlagigen Leiterplatte - auch von deren innerem Aufbau. Sofern die Kopplungseinrichtung metallisierte Oberflächen aufweist, hat auch die Metallisierung, insbesondere die Oberflächenrauigkeit Einfluss auf die Übertragungseigenschaften. Um eine verlustarme Übertragung der Mikrowellensignale zwischen dem Hochfrequenzbaustein und der Hohlleiterstruktur zu erreichen, sind deshalb spezielle Anpassungsnetzwerke erforderlich. Aufgrund unvermeidlicher Fertigungstoleranzen bei der Herstellung der Leiterplatten ist die Auslegung der Anpassungsnetzwerke relativ aufwendig.

Wenn Radarsensoren in verschiedenen Ausführungsvarianten mit unterschiedlichen Hohlleiterstrukturen und/oder unterschiedlichen Hochfrequenzbausteinen hergestellt werden, ist in der Regel eine Anpassung der Leiterplatte und der darin gebildeten Kopplungseinrichtung an die jeweilige Ausführungsvariante erforderlich. JP2008252207A offenbart ein Hochfrequenzmodul, wie z. B. ein fahrzeuginternes Millimeterwellenradar, mit einer Kopplungseinrichtung zur Übertragung von Mikrowellensignalen zwischen einem Hochfrequenzbaustein und einer Hohlleiterstruktur.

### Offenbarung der Erfindung

Aufgabe der Erfindung ist es, einen Radarsensor der eingangs genannten Art zu schaffen, bei dem sich die Kopplungseinrichtung einfacher an die übrigen Komponenten anpassen lässt.

Diese Aufgabe wird erfindungsgemäß dadurch gelöst, dass die Kopplungseinrichtung einen separat von der Leiterplatte hergestellten dielektrischen Wellenleiter aufweist. Dielektrische Wellenleiter sind Leiter, die aus einem dielektrischen Material bestehen und in dem sich die Mikrowellen auf Grund von Brechung und/oder Reflexion nur im Inneren des Leiters ausbreiten können.

Da der dielektrische Wellenleiter nicht Bestandteil der Leiterplatte ist, sind seine Wellenleitungseigenschaften von den Eigenschaften der Leiterplatte unabhängig, auch dann, wenn der dielektrische Wellenleiter durch eine Bohrung oder Durchführung der Leiterplatte verläuft. Die Anfälligkeit gegenüber Toleranzen bei der Herstellung der Leiterplatte, bei der Herstellung von metallisierten Oberflächen und dergleichen wird auf diese Weise erheblich reduziert.

Die Ankopplung an die Hohlleiterstruktur einerseits und an den Hochfrequenzbaustein andererseits lässt sich durch geeignete Wahl der Geometrie der betreffenden Enden des dielektrischen Wellenleiters optimieren, so dass verlustarme Übergänge geschaffen werden, ohne dass dazu irgendwelche Veränderungen an der Leiterplatte vorgenommen werden müssen. Darüber hinaus bietet der dielektrische Wellenleiter eine größere konstruktive Freiheit hinsichtlich der Anordnung der Ankopplungsstellen an der Hohlleiterstruktur und am Hochfrequenzbaustein.

Vorteilhafte Ausgestaltungen und Weiterbildungen der Erfindung sind in den Unteransprüchen angegeben.

Wenn der dielektrische Wellenleiter eine Bohrung der Leiterplatte durchsetzt, so kann der Wellenleiter durch geeignete Fixierungselemente, beispielsweise Feder- oder Klemmelemente, so in der Bohrung gehalten werden, dass er auf seinem gesamten Umfang zu den Innenwänden der Bohrung auf Abstand gehalten wird.

Wenn der Hochfrequenzbaustein beispielsweise ein BGA/eWLB-Gehäuse mit durch Lötbällen gebildeten elektrischen Kontakten hat, so kann die Ankopplung des Wellenleiters an den Hochfrequenzbaustein berührungslos über einen der Lötbälle erfolgen.

Alternativ darf der Wellenleiter den Lötball oder eine andere Kontaktfläche des BGA/eWLB berühren. Im dem Fall ist eine federnde Ausführung des Fixierelements erforderlich um immmer die Berührung zu gewährleisten.

Alternativ kann der Hochfrequenzbaustein eine integrierte Kopplungsstelle (Strahler und/oder Antenne) an der Oberfläche oder im Inneren seines Gehäuses aufweisen. In dem Fall lässt sich der dielektrische Wellenleiter so anordnen und führen, dass er direkt an diese Ankopplungsstelle ankoppelt.

Auf Seiten der Hohlleiterstruktur kann die Ankopplung beispielsweise dadurch erfolgen, dass der dielektrische Wellenleiter in ein offenes Ende eines Hohlleiters hineinragt.

Sowohl auf der Seite der Hohlleiterstruktur als auch auf der Seite des Hochfrequenzbausteins kann der dielektrische Wellenleiter ein beträchtliches Stück aus der Bohrung der Leiterplatte herausragen. Dieser herausragende Abschnitt des Wellenleiters kann wahlweise auch abgewinkelt oder gekrümmt verlaufen, so dass auch weiter von der Bohrung der Leiterplatte entfernte Ankopplungsstellen der Hohlleiterstruktur bzw. des Hochfrequenzbausteins erreicht werden können.

Im folgenden werden Ausführungsbeispiele anhand der Zeichnung näher erläutert.

Es zeigen:
- Fig. 1: einen Teilschnitt einer Leiterplatte, einer Hohlleiterstruktur, eines Hochfrequenzbausteins und eine Kopplungseinrichtung gemäß der Erfindung;
- Fig. 2: eine Detailvergrößerung zu Fig. 1, zur Illustration einer Befestigungsweise für einen dielektrischen Wellenleiter;
- Fig. 3: einen Schnitt längs der Linie III-III in Fig. 2;
- Fig. 4: eine perspektivische Teilansicht einer Hohlleiterstruktur, einer Leiterplatte und eines dielektrischen Wellenleiters gemäß einem anderen Ausführungsbeispiel; und
- Fig. 5 bis 7: Teilschnitte analog zu Fig. 1, für unterschiedliche Arten der Ankopplung des dielektrischen Wellenleiters an den Hochfrequenzbaustein.

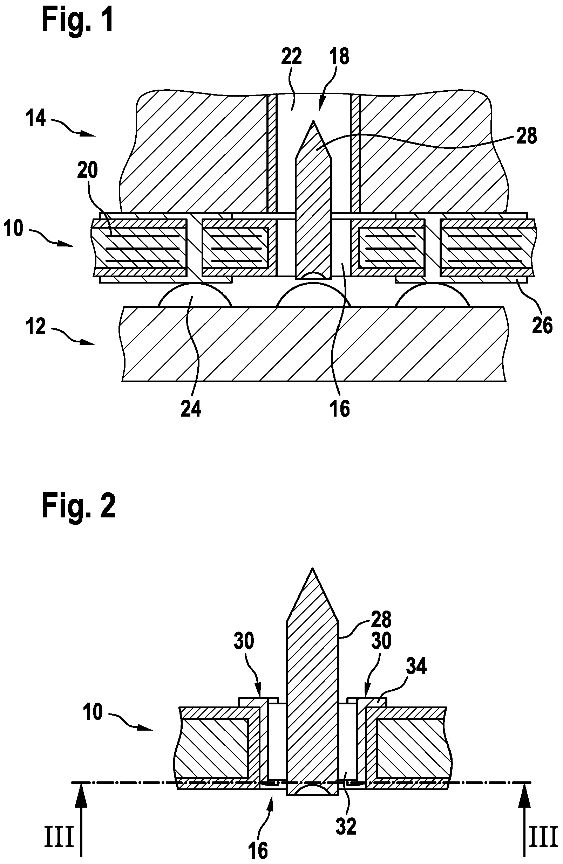

In Fig. 1 ist in einem Schnitt ein Teil einer Leiterplatte 10 (gedruckte Schaltungsplatine; PCB) eines Radarsensors gezeigt, die auf einer Seite (der Unterseite in Fig. 1) mit einem Hochfrequenzbaustein 12 und auf der entgegengesetzten Seite mit einer Hohlleiterstruktur 14 bestückt ist. Der Hochfrequenzbaustein 12 und die Hohlleiterstruktur 14 sind über eine durch eine Bohrung 16 der Leiterplatte 10 hindurchführende Kopplungseinrichtung 18 miteinander verbunden, so dass ein im Hochfrequenzbaustein 12 erzeugtes Mikrowellensignal in die Hohlleiterstruktur 14 eingekoppelt werden kann. Beispielsweise kann es sich bei der Hohlleiterstruktur 14 um eine Hohlleiterantenne handeln, über die das Mikrowellensignal abgestrahlt wird. Umgekehrt können Radarechos, die von der Hohlleiterantenne empfangen wurden, über die Kopplungseinrichtung 18 an den Hochfrequenzbaustein 12 übermittelt und dort weiter ausgewertet werden.

Die Leiterplatte 14 weist im gezeigten Beispiel mehrere parallele elektrisch leitfähige Lagen 20 auf, die verschiedene, hier nicht gezeigte, Komponenten des Radarsensors miteinander verbinden. Die Hohlleiterstruktur 14 ist direkt auf der Leiterplatte 10 angeordnet und weist zur Ankopplung an den Hochfrequenzbaustein 12 einen Hohlleiter 22 auf, der mit der Bohrung 16 der Leiterplatte ausgerichtet ist und zur Leiterplatte 10 hin offen ist.

Der Hochfrequenzbaustein 12, beispielsweise ein MMIC (Monolithic Microwave Integrated Circuit) oder ein SoC (System on Chip), hat im gezeigten Beispiel ein BGA/eWLB-Gehäuse, das ein Gitter von Lötbällen 24 zur Kontaktierung und Befestigung an der Leiterplatte 10 aufweist. Zwei dieser Lötbälle 24 stehen im gezeigten Beispiel in elektrischem Kontakt mit einer Schirmung 26, die die Kopplungseinrichtung 18 mit Abstand umgibt.

Kernstück der Kopplungseinrichtung 18 ist ein stiftförmiger dielektrischer Wellenleiter 28, der sich frei durch die Bohrung 16 der Leiterplatte 10 erstreckt und auf eine in Fig. 1 nicht näher gezeigte Weise so in dieser Bohrung gehalten ist, dass er mit einem Ende in den Hohlleiter 22 hineinragt, während das entgegengesetzte (untere) Ende berührungsfrei einem der Lötbälle 24 gegenüberliegt, über den das Mikrowellensignal in den Wellenleiter 28 eingekoppelt oder aus diesem ausgekoppelt wird. Die Geometrien der entgegengesetzten Enden des dielektrischen Wellenleiters 28 sind so an die Geometrien des Hohlleiters 22 und des Lötballs angepasst, dass eine verlustarme Übertragung der Mikrowellenleistung erreicht wird.

Ein Beispiel für eine mögliche Befestigungsweise des dielektrischen Wellenleiters 28 in der Bohrung 16 der Leiterplatte 10 ist in Fig. 2 dargestellt. In diesem Beispiel ist der Wellenleiter 28 in einem Stück mit zwei einander diametral gegenüberliegenden Klemmelementen 30 ausgebildet, die an der Innenwand der Bohrung 16 anliegen und über federnde Stege 32 mit dem Hauptteil des Wellenleiters verbunden sind. Auf diese Weise wird der Wellenleiter 28 in der Bohrung 16 zentriert und zu den Wänden der Bohrung auf Abstand gehalten. Die Klemmelemente 30 weisen am unteren Ende jeweils eine Einführungsschräge auf, die das Einsetzen des Wellenleiters 28 in die Bohrung 16 erleichtern. Am entgegengesetzten Ende haben die Klemmelemente jeweils einen Anschlag 34, der im endgültig montierten Zustand auf der Oberfläche der Leiterplatte 10 aufliegt und so eine präzise axiale Position für den Wellenleiter vorgibt.

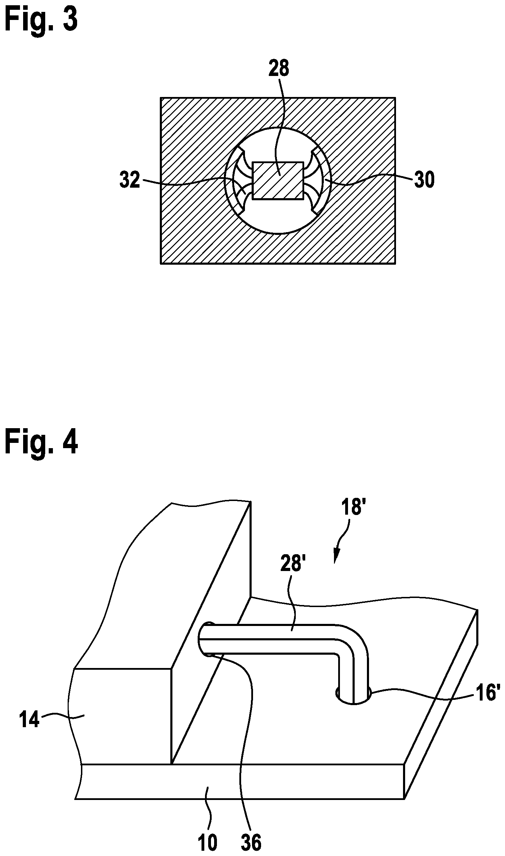

Der eigentliche Wellenleiter 28 hat im gezeigten Beispiel einen rechteckigen Querschnitt, wie in Fig. 3 zu erkennen ist. Auch der Querschnitt der Klemmelemente 30 und die Konturen der federnden Stege 32 sind in Fig. 3 zu erkennen.

Es sind jedoch auch alternative Befestigungsweisen für den dielektrischen Wellenleiter 28 denkbar. Beispielsweise könnte der Wellenleiter dadurch fixiert werden, dass die Bohrung 16 mit einer den Wellenleiter umgebenden Füllmasse ausgefüllt wird, die eine geeignet gewählte Dielektrizitätskonstante hat.

Fig. 4 zeigt in einer perspektivischen Ansicht ein anderes Ausführungsbeispiel einer Kopplungseinrichtung 18', die eine Bohrung 16' der Leiterplatte 10 durchsetzt und die Hohlleiterstruktur 14 mit einem Hochfrequenzbaustein verbindet, der in Fig. 4 unsichtbar an der Unterseite der Leiterplatte 10 sitzt. Die Hohlleiterstruktur 14 hat in diesem Beispiel eine Ankopplungsstelle 36, die seitlich in einer rechtwinklig zur Ebene der Leiterplatte 10 verlaufenden Seitenwand der Hohlleiterstruktur angeordnet ist.

Kernstück der Kopplungseinrichtung 18' ist in diesem Fall ein wiederum im Querschnitt rechteckiger dielektrischer Wellenleiter 28' der um ein beträchtliches Stück aus der Bohrung 16' herausragt und rechtwinklig abgewinkelt ist, so dass er mit seinem abgewinkelten Ende in die Ankopplungsstelle 36 hineinragt.

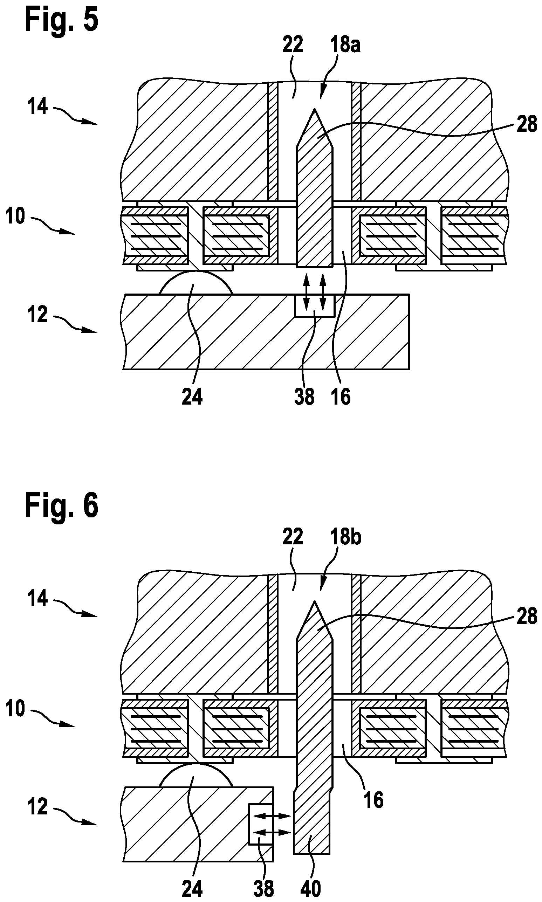

Fig. 5 bis 7 zeigen Beispiele für Kopplungseinrichtungen 18a, 18b, 18c, die sich von der Kopplungseinrichtung 18 nach Fig. 1 durch unterschiedliche Arten der Ankopplung des dielektrischen Wellenleiters 28 an den Hochfrequenzbaustein 12 unterscheiden.

In Fig. 5 ist der Hochfrequenzbaustein 12 so an der Leiterplatte 10 angeordnet, dass er die Bohrung 16 der Leiterplatte mit seinem Rand überragt. In das Gehäuse des Hochfrequenzbausteins 12 ist auf der der Leiterplatte 10 zugewandten Seite in einer mit der Bohrung 16 fluchtenden Position eine integrierte Ankopplungsstelle 38 (Strahler und/oder Antenne oder wahlweise direkter Kontakt) gebildet, die dem Ende des dielektrischen Wellenleiters 28 gegenüberliegt.

In Fig. 6 ist die Anordnung so gewählt, dass die Bohrung 16 außerhalb des Umrisses des Hochfrequenzbausteins 12 liegt. Die Ankopplungsstelle 38 befindet sich in diesem Fall in einer Seitenwand des Hochfrequenzbausteins, und der dielektrische Wellenleiter 28 hat einen aus der Bohrung 16 herausragenden Ankopplungsabschnitt 40, der so geformt ist, dass er der Ankopplungsstelle 38 in passendem Abstand gegenüberliegt.

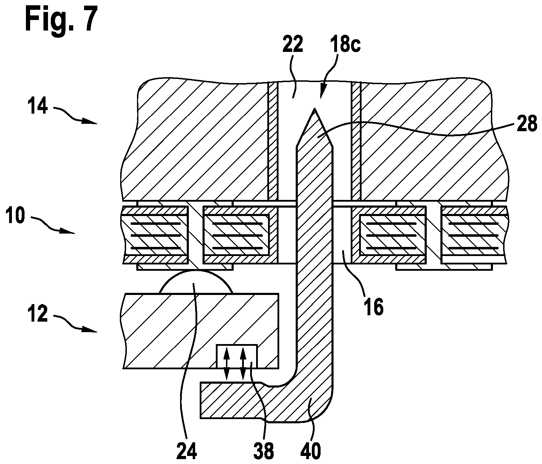

In Fig. 7 befindet sich der Ankopplungsabschnitt 38 auf der von der Leiterplatte 10 abgewandten Seite des Hochfrequenzbausteins 12, und der Ankopplungsabschnitt 40 des Wellenleiters 28 ist um den Rand des Hochfrequenzbausteins 12 herumgeführt.

## Patentansprüche

1. Radarsensor mit einer Hohlleiterstruktur (14) und einem Hochfrequenzbaustein (12), die auf entgegengesetzten Seiten einer Leiterplatte (10) angeordnet sind, und mit einer Kopplungseinrichtung (18; 18'; 18a-c) zur Übertragung von Mikrowellensignalen zwischen dem Hochfrequenzbaustein (12) und der Hohlleiterstruktur (14), wobei die Kopplungseinrichtung (18; 18'; 18a-c) einen separat von der Leiterplatte (10) hergestellten dielektrischen Wellenleiter (28; 28') aufweist.

2. Radarsensor nach Anspruch 1, bei dem der dielektrische Wellenleiter (28; 28') sich durch eine Bohrung (16, 16') der Leiterplatte (10) erstreckt.

3. Radarsensor nach Anspruch 2, bei dem der dielektrische Wellenleiter (28; 28') so in der Bohrung (16; 16') der Leiterplatte (10) gehalten ist, dass er auf seinem gesamten Umfang einen Abstand zur Innenwand der Bohrung (16; 16') aufweist.

4. Radarsensor nach Anspruch 2 oder 3, bei dem der dielektrische Wellenleiter (28) mittels Klemmelementen (30) in der Bohrung (16) fixiert ist.

5. Radarsensor nach Anspruch 4, bei dem die Klemmelemente (30) über federnde Stege (32) mit dem Wellenleiter (28) verbunden sind und klemmend gegen die Umfangsfläche der Bohrung (16) vorgespannt sind.

6. Radarsensor nach einem der Ansprüche 2 - 5, bei dem der dielektrische Wellenleiter (28') eine Bohrung (16') der Leiterplatte (10) durchsetzt und auf der Seite der Hohlleiterstruktur (14) einen aus der Bohrung (16') herausragenden Abschnitt aufweist, der einen Abstand zwischen der Bohrung (16') und einer Ankopplungsstelle (36) der Hohlleiterstruktur (14) überbrückt.

7. Radarsensor nach Anspruch 6, bei dem der aus der Bohrung (16') herausragende Abschnitt des dielektrischen Wellenleiters (18') abgewinkelt oder gekrümmt ist.

8. Radarsensor nach einem der vorstehenden Ansprüche, bei dem der Hochfrequenzbaustein (12) ein Gehäuse aufweist, das mittels Lötbällen (24) an der Leiterplatte (10) fixiert und kontaktiert ist und bei dem einer der Lötbälle (24) einen Ankopplungspunkt zur Ankopplung an den dielektrischen Wellenleiter (28) bildet, dessen eines Ende diesem Lötball gegenüberliegt.

9. Radarsensor nach einem der Ansprüche 1 bis 7, bei dem der Hochfrequenzbaustein (12) eine integrierte Ankopplungsstelle (38) zur Ankopplung an den dielektrischen Wellenleiter (28) aufweist und ein Ende des Wellenleiters (28) dieser Ankopplungsstelle gegenüberliegt.

10. Radarsensor nach Anspruch 9, bei dem sich die Ankopplungsstelle (38) in einem der Leiterplatte (10) zugewandten Teil des Hochfrequenzbausteins (12) befindet.

11. Radarsensor nach Anspruch 9, bei dem sich die Ankopplungsstelle (38) in einer rechtwinklig zur Ebene der Leiterplatte (10) verlaufenden Seitenfläche des Hochfrequenzbausteins (12) befindet.

12. Radarsensor nach Anspruch 9, bei dem sich die Ankopplungsstelle (38) in einer von der Leiterplatte (10) abgewandten Oberfläche des Hochfrequenzbausteins (12) befindet.

## Claims

1. Radar sensor having a waveguide structure (14) and a high-frequency component (12), which are arranged on opposite sides of a printed circuit board (10), and having a coupling device (18; 18'; 18a-c) for transmitting microwave signals between the high-frequency component (12) and the waveguide structure (14), the coupling device (18; 18'; 18a-c) having a dielectric waveguide (28; 28') which is produced separately from the printed circuit board (10).

2. Radar sensor according to Claim 1, wherein the dielectric waveguide (28; 28') extends through a hole (16, 16') in the printed circuit board (10).

3. Radar sensor according to Claim 2, wherein the dielectric waveguide (28; 28') is held in the hole (16; 16') in the printed circuit board (10) in such a way that it has, over its entire circumference, a distance from the inner wall of the hole (16; 16').

4. Radar sensor according to Claim 2 or 3, wherein the dielectric waveguide (28) is fixed in the hole (16) by means of clamping elements (30).

5. Radar sensor according to Claim 4, wherein the clamping elements (30) are connected to the waveguide (28) via resilient webs (32) and are preloaded against the circumferential surface of the hole (16) in a clamping manner.

6. Radar sensor according to one of Claims 2-5, wherein the dielectric waveguide (28') passes through a hole (16') in the printed circuit board (10) and has, on the side of the waveguide structure (14), a section which protrudes from the hole (16') and which bridges a distance between the hole (16') and a coupling point (36) of the waveguide structure (14).

7. Radar sensor according to Claim 6, wherein that section of the dielectric waveguide (18') which protrudes from the hole (16') is bent or curved.

8. Radar sensor according to one of the preceding claims, wherein the high-frequency component (12) has a housing which is fixed and contact-connected to the printed circuit board (10) by means of solder balls (24) and wherein one of the solder balls (24) forms a coupling point for coupling to the dielectric waveguide (28), one end of which lies opposite this solder ball.

9. Radar sensor according to one of Claims 1 to 7, wherein the high-frequency component (12) has an integrated coupling point (38) for coupling to the dielectric waveguide (28) and one end of the waveguide (28) lies opposite this coupling point.

10. Radar sensor according to Claim 9, wherein the coupling point (38) is located in a part of the high-frequency component (12) that faces the printed circuit board (10).

11. Radar sensor according to Claim 9, wherein the coupling point (38) is located in a lateral surface of the high-frequency component (12) that runs perpendicular to the plane of the printed circuit board (10).

12. Radar sensor according to Claim 9, wherein the coupling point (38) is located in a surface of the high-frequency component (12) that faces away from the printed circuit board (10).

## Revendications

1. Capteur radar comportant une structure de guide d'ondes (14) et un module haute fréquence (12) qui sont disposés sur des côtés opposés d'une carte de circuit imprimé (10), et un dispositif de couplage (18 ; 18' ; 18a-c) pour transférer des signaux micro-ondes entre le module haute fréquence (12) et la structure de guide d'ondes (14), le dispositif de couplage (18 ; 18' ; 18a-c) ayant un guide d'ondes diélectrique (28 ; 28') réalisé séparément de la carte de circuit imprimé (10).

2. Capteur radar selon la revendication 1, dans lequel le guide d'ondes diélectrique (28 ; 28') s'étend à travers un alésage (16, 16') de la carte de circuit imprimé (10).

3. Capteur radar selon la revendication 2, dans lequel le guide d'ondes diélectrique (28 ; 28') est maintenu dans l'alésage (16 ; 16') de la carte de circuit imprimé (10) de telle sorte qu'il présente sur toute sa périphérie un espace par rapport à la paroi intérieure de l'alésage (16 ; 16').

4. Capteur radar selon la revendication 2 ou 3, dans lequel le guide d'ondes diélectrique (28) est fixé dans l'alésage (16) au moyen d'éléments de serrage (30).

5. Capteur radar selon la revendication 4, dans lequel les éléments de serrage (30) sont reliés au guide d'ondes (28) par des nervures élastiques (32) et sont précontraints par serrage contre la surface périphérique de l'alésage (16).

6. Capteur radar selon l'une des revendications 2 à 5, dans lequel le guide d'ondes diélectrique (28') passe à travers un alésage (16') de la carte de circuit imprimé (10) et présente, du côté de la structure de guide d'ondes (14), une partie qui fait saillie hors de l'alésage (16') et qui comble un espace entre l'alésage (16') et un point de couplage (36) de la structure de guide d'ondes (14).

7. Capteur radar selon la revendication 6, dans lequel la partie du guide d'ondes diélectrique (18') qui fait saillie hors de l'alésage (16') est coudée ou incurvée.

8. Capteur radar selon l'une des revendications précédentes, dans lequel le module haute fréquence (12) comporte un boîtier qui est fixé à la carte de circuit imprimé (10) et mis en contact avec cette dernière au moyen de billes de soudure (24), et dans lequel l'une des billes de soudure (24) forme un point de couplage pour le couplage au guide d'ondes diélectrique (28), dont une extrémité est située en face de ladite bille de soudure.

9. Capteur radar selon l'une des revendications 1 à 7, dans lequel le module haute fréquence (12) comporte un point de couplage intégré (38) pour le couplage au guide d'ondes diélectrique (28), et une extrémité du guide d'ondes (28) est située en face dudit point de couplage.

10. Capteur radar selon la revendication 9, dans lequel le point de couplage (38) se trouve dans une partie du module haute fréquence (12) qui est orientée vers la carte de circuit imprimé (10).

11. Capteur radar selon la revendication 9, dans lequel le point de couplage (38) se trouve dans une surface latérale du module haute fréquence (12) qui s'étend perpendiculairement au plan de la carte de circuit imprimé (10).

12. Capteur radar selon la revendication 9, dans lequel le point de couplage (38) se trouve dans une surface du module haute fréquence (12) qui est orientée à l'opposé de la carte de circuit imprimé (10).
